# EUROPÄISCHE PATENTSCHRIFT

(11) **EP 2 379 957 B1**
(45) Veröffentlichungstag und Bekanntmachung des Hinweises auf die Patenterteilung: **12.10.2016**
(21) Anmeldenummer: 10708689.4
(22) Anmeldetag: 19.01.2010
(51) Int. Cl.: F24J 2/54

(54) **ANLAGE ZUR ERZEUGUNG VON ELEKTRISCHER ENERGIE MITTELS FOTOVOLTAISCHER ELEMENTE**
SYSTEM FOR GENERATING ELECTRIC ENERGY BY USING PHOTOVOLTAIC ELEMENTS
INSTALLATION DE PRODUCTION D'ÉNERGIE ÉLECTRIQUE AU MOYEN D'ÉLÉMENTS PHOTOVOLTAÏQUES

(30) Priorität: 19.01.2009 AT 762009
(43) Veröffentlichungstag der Anmeldung: 26.10.2011
(73) Patentinhaber: Innova Patent GmbH, 6922 Wolfurt (AT)
(72) Erfinder: ERHART, Philipp, A-6971 HARD (AT); CZALOUN, Hans Günter, I-39040 Seis (IT)
(74) Vertreter: Beer & Partner Patentanwälte KG
(86) Internationale Anmeldenummer: PCT/AT2010/000015
(87) Internationale Veröffentlichungsnummer: WO 2010/081184

(56) Entgegenhaltungen:
- WO-A1-2006/130892
- WO-A2-2008/064382
- JP-A- 2003 329 963
- US-A- 4 466 423

## Beschreibung

Die gegenständliche Erfindung betrifft eine Anlage zur Gewinnung von elektrischer Energie mittels fotovoltaischer Elemente, welche sich auf einem durch Tragseile und Stellseile od.dgl. gebildeten Tragwerk befinden und welche um zumindest angenähert vertikal ausgerichtete Achsen verschwenkbar sind, wodurch sie der Ost-West-Bewegung der Sonne nachführbar sind, sowie weiters um zumindest angenähert horizontal ausgerichtete Achsen verschwenkbar sind, wodurch sie auf die Höhe des Sonnenstandes einstellbar sind, wobei die fotovoltaischen Elemente auf mehreren zueinander zumindest angenähert parallelen und angenähert horizontal ausgerichteten Tragbalken od.dgl. befestigt sind, wobei die Tragbalken od.dgl. an einem ihrer beiden Enden an einem Tragseil od.dgl. einerseits um eine zumindest angenähert vertikale Achse verschwenkbar und andererseits um ihre Längsachse verdrehbar gelagert sind und wobei die Tragbalken an ihrem anderen Ende mit einer Schwenk- und Dreheinrichtung, welche durch zumindest ein Trag- und Stellseil gebildet ist, gekuppelt sind.

Eine derartige Anlage zur Gewinnung von elektrischer Energie ist aus der JP 2003-32-9963 A bekannt.

Eine Anlage zur Erzeugung von elektrischer Energie mittels fotovoltaischer Elemente, welche sich auf einem insbesondere durch Tragseile und Stellseile od.dgl. gebildeten Tragwerk befinden, welche um zumindest angenähert vertikal ausgerichtete Achsen verschwenkbar sind, wodurch sie der Ost-West-Bewegung der Sonne nachführbar sind und welche weiters um zumindest angenähert horizontal ausgerichtete Achsen verschwenkbar sind, wodurch sie auf die Höhe des Sonnenstandes einstellbar sind, ist aus der WO 2008/064382 A2 und der WO 2006/130892 A1 bekannt. Bei dieser bekannten Anlage sind die einzelnen fotovoltaischen Elemente als rechteckige Platten ausgebildet, die mit von ihren beiden Enden horizontal abragenden Achszapfen ausgebildet sind, welche an ihren freien Enden an Stellseile, welche über Umlenkscheiben geführt und in sich geschlossen sind, angelenkt sind. Die beiden Trume eines ersten dieser beiden Stellseile sind um zwei in einer vertikalen Ebene ausgerichtete Umlenkscheiben in einer vertikalen Ebene bewegbar und die beiden Trume des zweiten dieser beiden Stellseile sind um zwei in einer horizontalen Ebene ausgerichtete Umlenkscheiben in einer horizontalen Ebene bewegbar, wobei die jeweils einander zugeordneten Trume gegeneinander verstellbar sind. Am ersten Stellseil sind die fotovoltaischen Elemente um vertikal ausgerichtete Achsen verschwenkbar gelagert, wodurch sie bei einer Verstellung des zweiten Stellseiles der Ost-West-Bewegung der Sonne nachführbar sind. Am zweiten Stellseil sind die fotovoltaischen Elemente um horizontale Achsen verschwenkbar gelagert, wodurch sie durch Verstellung des ersten Stellseiles dem Höhenstand der Sonne nachführbar sind. Da dabei jedes fotovoltaische Element an zwei unterschiedlich ausgerichtete Stellseile angelenkt ist und für sämtliche Stellseile gesonderte Antriebe vorgesehen sind, weist diese bekannte Anlage eine sehr aufwändige konstruktive Gestaltung auf.

Der gegenständlichen Erfindung liegt somit die Aufgabe zugrunde, eine Anlage zur Erzeugung von elektrischer Energie unter Verwendung einer Vielzahl von auf den jeweiligen Sonnenstand einstellbaren fotovoltaischen Elementen zu schaffen, bei welcher der dem bekannten Stand der Technik anhaftende Nachteil vermieden wird, welche also gegenüber den bekannten konstruktiven Gestaltungen einen wesentlich vereinfachten Aufbau aufweist. Diese Aufgabe wird erfingdungsgemäß dadurch gelöst, dass mindestens einer der Tragbalken auf einer Tragsäule, Tragstütze od.dgl. gegenüber dieser um seine horizontal ausgerichtete Achse verdrehbar und um eine vertikale Längsachse der Tragsäule, Tragstütze od.dgl. verschwenkbar gelagert ist, und dass weiters auf einer der Tragsäulen od.dgl. einerseits eine Schwenkeinrichtung und andererseits eine Dreheinrichtung für diesen Tragbalken vorgesehen sind.

Vorzugsweise ist die Schwenk- und Dreheinrichtung durch ein mit zwei zueinander angenähert parallelen Trumen versehenes Trag- und Stellseil od.dgl. gebildet, welches in seiner Längsrichtung verstellbar ist und dessen beide Trume gegeneinander verstellbar sind. Weiters befinden sich vorzugsweise zwischen den beiden Trumen des Trag- und Stellseiles an diese angelenkte Querstreben, welche mit den zugeordneten Enden der Tragbalken od.dgl. fest verbunden sind.

Mindestens einer der Tragbalken od.dgl. ist auf einer Tragsäule, Tragstütze od.dgl. gegenüber dieser verschwenkbar und verdrehbar gelagert, wobei weiters auf der Tragsäule einerseits eine Schwenkeinrichtung und andererseits eine Dreheinrichtung für diesen Tragbalken od.dgl. vorgesehen sind. Weiters sind vorzugsweise die Schwenkbewegungen und die Drehbewegungen des auf der Tragsäule, Tragstütze od.dgl. gelagerten Tragbalkens über die Längsverstellung des Trag- und Stellseiles und über die gegenläufige Verstellung der beiden Trume des mit diesem Tragbalken gekuppelten Trag- und Stellseiles auf die anderen Tragbalken od.dgl. übertragbar.

Gemäß einer bevorzugten Ausführungsform einer erfindungsgemäßen Anlage zur Erzeugung von elektrischer Energie ist an den beiden Enden des insbesondere durch Trag- und Stellseile od.dgl. gebildeten Tragwerkes jeweils eine Tragsäule, Tragstütze od.dgl. vorgesehen, an welchen die dort befindlichen Tragbalken od.dgl. verschwenkbar bzw. verdrehbar gelagert sind, ist mindestens eine der beiden Tragsäulen, Tragstützen od.dgl. mit Antrieben für die Verschwenkung und für die Verdrehung des zugeordneten Tragbalkens od.dgl. ausgebildet und sind die Tragbalken od.dgl. für die fotovoltaischen Elemente an einem ihrer beiden Enden an einem ersten Tragseil um eine zumindest angenähert vertikale Achse verschwenkbar sowie um ihre Längsachse verdrehbar gelagert und mittels des den anderen Enden zugeordneten Trag- und Stellseiles miteinander auf Verschwenkung um zumindest angenähert vertikale Achsen und auf Verdrehung um ihre Längsachsen gekuppelt.

Der Gegenstand der Erfindung ist nachstehend anhand von zwei in der Zeichnung dargestellten Ausführungsbeispielen näher erläutert. Es zeigen:
- FIG.1: ein erstes Ausführungsbeispiel einer erfindungsgemäßen Anlage zur Erzeugung von elektrischer Energie mittels fotovoltaischer Elemente, in axonometrischer Darstellung,
- FIG.2: das Ausführungsbeispiel gemäß FIG.1, in gegenüber FIG.1 vergrößertem Maßstab und in abgebrochener Darstellung,
- FIG.3: das Ausführungsbeispiel gemäß FIG.1, in Vorderansicht,
- FIG.4: ein Detail der FIG.3,
- FIG.4a, FIG.4b: die Details A und B der FIG.4, in gegenüber dieser vergrößertem Maßstab und im Schnitt,
- FIG.5: ein zweites Ausführungsbeispiel einer erfindungsgemäßen fotovoltaischen Anlage, in axonometrischer Darstellung, und
- FIG.5a, FIG.5b: die Details C und D der FIG.5 in gegenüber dieser vergrößertem Maßstab.

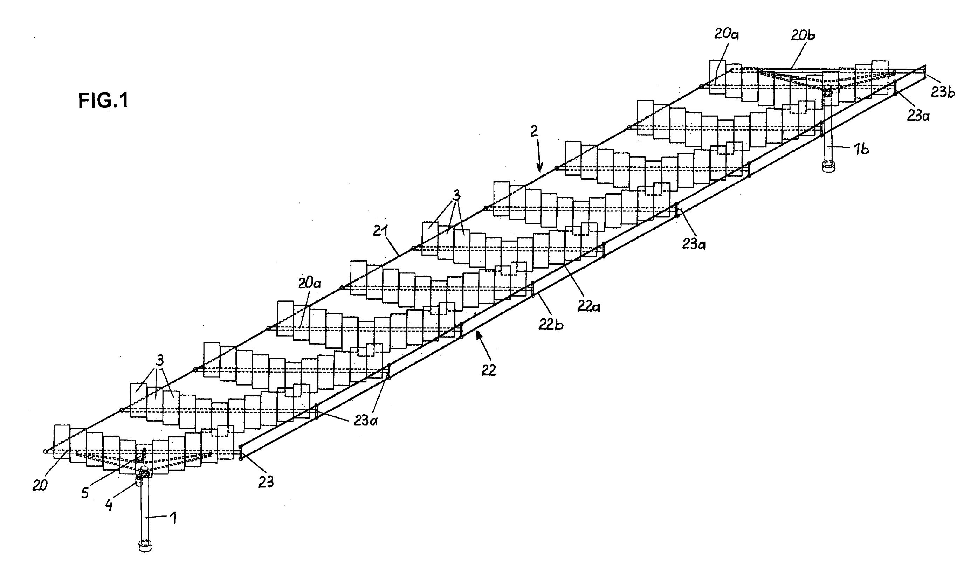

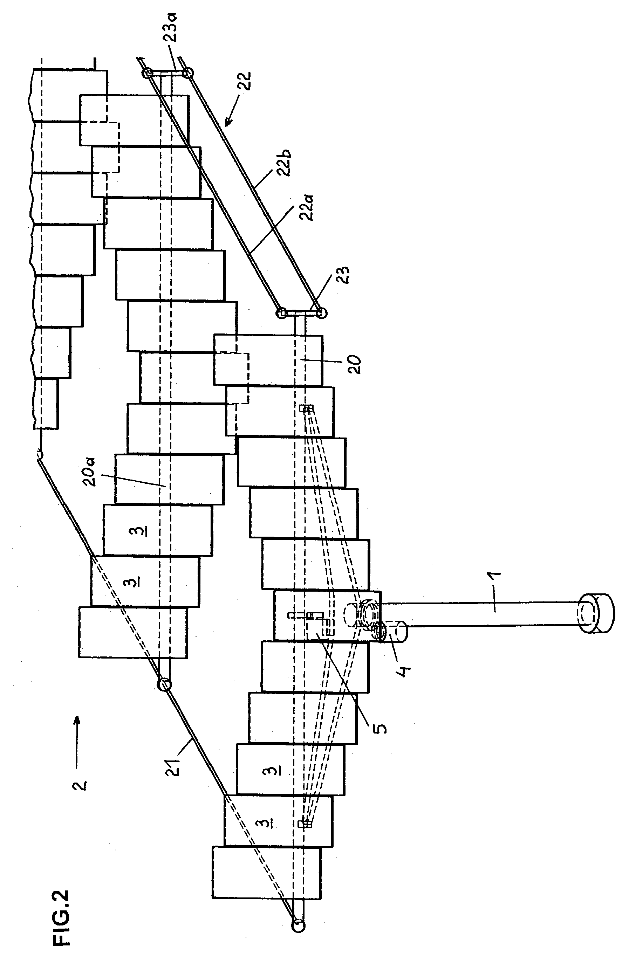

Die in den FIG.1 bis FIG.3 dargestellte Anlage zur Erzeugung von elektrischer Energie mittels fotovoltaischer Elemente weist zwei Tragsäulen 1 und 1b auf, auf welchen sich ein Tragwerk 2 für fotovoltaische Elemente 3 befindet. Das Tragwerk 2 besteht aus einem Tragseil 21 und aus einem von diesen im Abstand befindlichen, zum Tragseil 21 parallel ausgerichteten Trag- und Stellseil 22 mit zwei Trumen 22a und 22b, wobei sich zwischen dem Tragseil 21 und dem Trag- und Stellseil 22 Tragbalken 20, 20a und 20b für das Tragwerk 2 der fotovoltaischen Elemente 3 befinden, welche an das Tragseil 21 und an das Trag- und Stellseil 22 angelenkt sind. Der Tragbalken 20 bzw. der Tragbalken 20b sind auf den Tragsäulen 1 bzw. 1b verschwenkbar gelagert, wodurch das Tragwerk 2 von den Tragsäulen 1 und 1b getragen ist. Die Tragbalken 20a sind demgegenüber vom Tragseil 21 und vom Trag- und Stellseil 22 getragen. An den Tragbalken 20 und 20a sind jeweils Gruppen einer Vielzahl von fotovoltaischen Elementen 3 befestigt. Die beiden Trume 22a und 22b des Trag- und Stellseiles 22, welche vertikal übereinander angeordnet sind, sind miteinander mittels Querstreben 23 und 23a verbunden, welche an die beiden Trume 22a und 22b des Trag- und Stellseiles 22, z.B. mittels Kugelgelenken, angelenkt sind. Die den Tragseilen 21 zugeordneten Enden der Tragbalken 20 und 20a sind am Tragseil 21 einerseits um jeweils eine vertikale Achse verschwenkbar um die Längsachsen der Tragbalken 20 und 20a verdrehbar gelagert. Demgegenüber sind die anderen Enden der Tragbalken 20 und 20a mit den Querstreben 23 und 23a starr verbunden, wobei sich diese Enden angenähert in der Mitte zwischen den beiden Trumen 22a und 22b des Trag- und Stellseiles 22 befinden.

An dem der Tragsäule 1b zugeordneten Ende des Tragwerkes 2 sind das Tragseil 21 und das Trag- und Stellseil 22 mittels des Tragbalkens 20b miteinander verbunden, wobei der Balken 20b an eine Querstrebe 23b angelenkt ist, welche sich zwischen den beiden Trumen 22a und 22b befindet.

Auf der Tragsäule 1 befindet sich ein erster Stellmotor 4, durch welchen der Tragbalken 20 um eine vertikale Achse in einer horizontalen Ebene verschwenkbar ist. Weiters befindet sich auf der Tragsäule 1 ein zweiter Stellmotor 5, durch welchen der Tragbalken 20 um seine horizontal ausgerichtete Achse verdrehbar ist.

Durch eine Verschwenkung des Tragbalkens 20 mittels des Antriebsmotors 4 in einer horizontalen Ebene wird diese Bewegung über die Querstrebe 23 auf das Trag- und Stellseil 22 übertragen, welches hierdurch translatorisch in einer horizontalen Ebene bewegt wird. Da diese Stellbewegung über die Querstreben 23a auf die Tragbalken 20a übertragen wird, werden somit sämtliche fotovoltaischen Elemente 3 um vertikale Achsen verschwenkt, wodurch sie der Ost-West-Bewegung der Sonne nachgeführt werden.

Durch den zweiten Stellmotor 5 wird der mit diesem gekuppelte Tragbalken 20 um seine Längsachse verdreht. Diese Drehbewegung wird mittels der Querstrebe 23 auf die beiden Trume 22a und 22b des Trag- und Stellseiles 22 übertragen, wodurch die beiden Trume 22a und 22b gegeneinander verstellt werden. Diese Stellbewegung wird über die Querstreben 23a an die mit diesen starr verbundenen Tragbalken 20a übertragen, wodurch die an diesen befestigten fotovoltaischen Elemente 3 verschwenkt werden, sodass sie der Höhe des Sonnenstandes nachgeführt werden.

Wie sich hieraus erweist, wird für die beiden Stellbewegungen der fotovoltaischen Elemente 3 nur ein einziges mit zwei Trumen 22a und 22b ausgebildetes Trag- und Stellseil 22 benötigt. Da sich zudem auf jedem der Tragbalken 20 und 20a eine Vielzahl von fotovoltaischen Elementen 3 befindet, wird auch dadurch eine maßgebliche Vereinfachung in der Ausbildung erzielt.

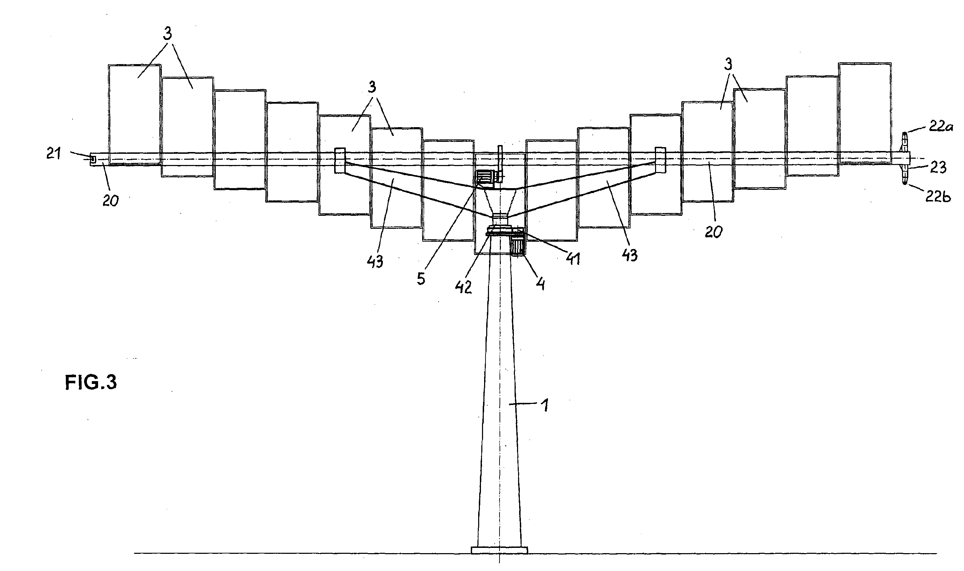

Wie dies weiters aus FIG.3 ersichtlich ist, befindet sich auf der Antriebswelle des Motors 4 ein Ritzel 41, welches mit einem um eine vertikale Achse verdrehbaren Zahnrad 42 zusammenwirkt. Mit dem Zahnrad 42 ist ein zweiarmiger Stellbalken 43 fest verbunden, welcher um die vertikale Drehachse des Zahnrades 42 verschwenkbar ist und welcher mit dem Tragbalken 20 fest verbunden ist. Da das linke Ende des Tragbalkens 20 am zugeordneten Tragseil 21 um die vertikale Drehachse verschwenkbar gelagert ist, kann hierdurch der Tragbalken 20 in einer horizontalen Ebene verschwenkt werden. Da mit dem rechten Ende des Tragbalkens 20 mittels der Querstrebe 23 die beiden Trume 22a und 22b auf Mitnahme verbunden sind, werden hierdurch auch die Querstreben 23a translatorisch in horizontaler Richtung bewegt, wodurch die an diesen befestigten Tragbalken 20a gleichfalls verschwenkt werden.

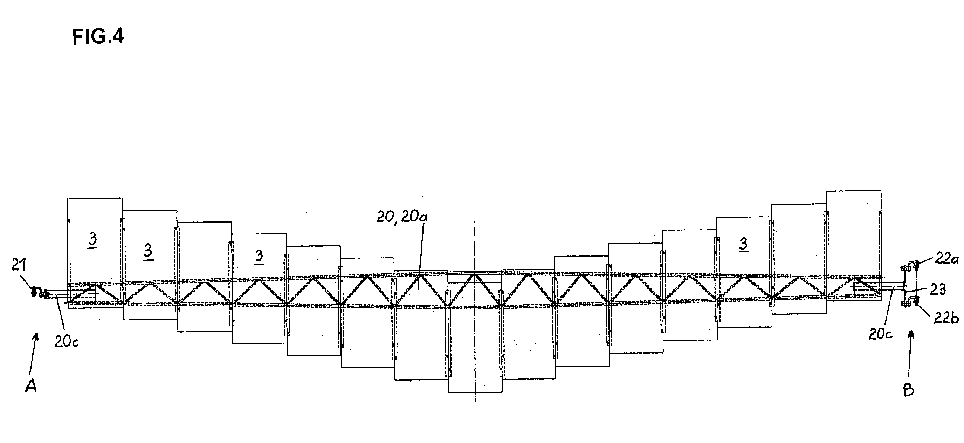

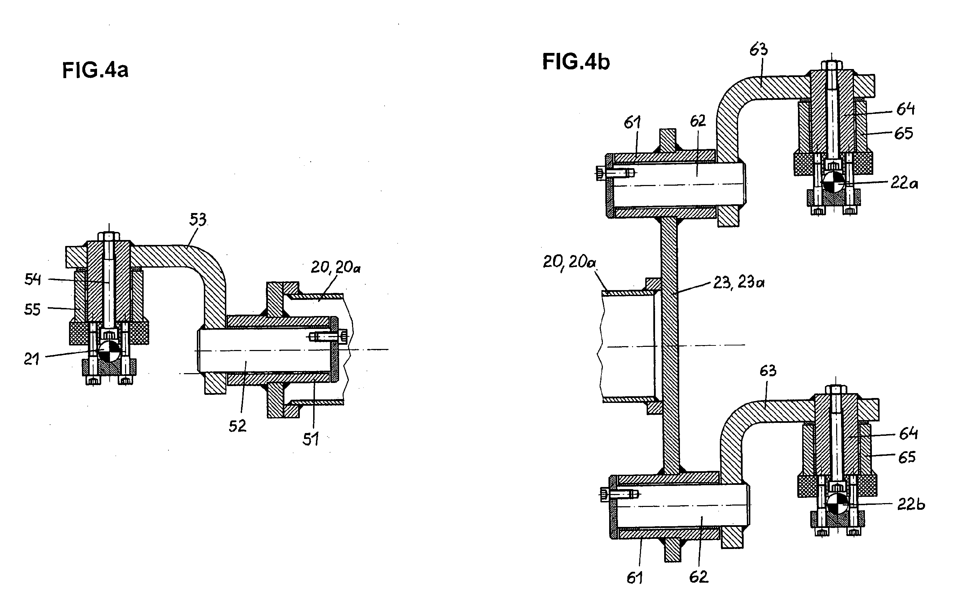

Wie dies aus FIG.4 ersichtlich ist, können die Tragbalken 20 und 20a als Fachwerk ausgebildet sein, welches an seinen beiden Enden mit Tragzapfen 20c versehen ist, welche am linken Ende an das Tragseil 21 angelenkt sind und am rechten Ende mit den Querstreben 23 und 23a verbunden sind, deren Enden an die beiden Trume 22a und 22b des Trag- und Stellseiles 22 angelenkt sind.

In den FIG.4a und FIG.4b ist die genaue Ausbildung der Befestigung der Tragbalken 20 und 20a am Tragseil 21 und an den beiden Trumen 22a und 22b des Trag- und Stellseiles 22 dargestellt:
Wie dies aus FIG.4a ersichtlich ist, ist das linke Ende der Tragbalken 20 und 20a mit einer Hülse 51 ausgebildet, in welcher ein Bolzen 52 gelagert ist, der mit den Tragbalken 20 und 20a koaxial ist. Somit sind die Tragbalken 20 und 20a jeweils um eine horizontal ausgerichtete Achse verdrehbar. Der Bolzen 52 ist mittels eines um 90° gekrümmten Bügels 53 mit einem vertikal ausgerichteten Bolzen 54 verbunden, welcher in einer mit diesem koaxialen Hülse 55 gelagert ist. Hierdurch sind die Tragbalken 20 und 20a um eine vertikale Achse verschwenkbar. Die Hülse 55 ist an das Tragseil 21 angeklemmt.

Das rechte Ende der Tragbalken 20 und 20a ist jeweils mit einer Querstrebe 23 und 23a fest verbunden, an deren freien Enden horizontal ausgerichtete Hülsen 61 befestigt sind. In diesen Hülsen 61 sind horizontal ausgerichtete Bolzen 62 gelagert. An den Bolzen 62 sind um 90° gekrümmte Bügel 63 befestigt, an deren anderen Enden vertikal ausgerichtete Bolzen 64 befestigt sind, welche in mit diesen koaxialen Hülsen 65 verdrehbar gelagert sind. Die Hülsen 65 sind an die beiden Trume 22a und 22b des Trag- und Stellseiles 22 angeklemmt.

Durch eine Verschwenkung des Tragbalkens 20 in einer horizontalen Ebene wird diese Stellbewegung über die Querstrebe 23 auf die Bügel 63 übertragen, wobei mittels der in den Hülsen 65 gelagerten Bolzen 64 eine gleichläufige Verstellung der beiden Trume 22a und 22b des Trag- und Stellseiles 22 bewirkt wird. Diese Verstellung wird über die Querstreben 23a auf die Tragbalken 20a übertragen. Durch diese Stellbewegungen werden die fotovoltaischen Elemente 3 der Ost-West-Bewegung der Sonne nachgeführt. Mittels der in den Hülsen 61 gelagerten Bolzen 62 und der Querstrebe 23 ist der Tragbalken 20 gegenüber den beiden Trumen 22a und 22b des Trag- und Stellseiles 22 verdrehbar, wobei eine Drehbewegung des Tragbalkens 20 durch die Verschwenkung der Querstrebe 23 eine gegenläufige Verstellung der beiden Trume 22a und 22b bewirkt, wodurch auch die Querstreben 23a verschwenkt und hierdurch die Tragbalken 20a verdreht werden. Durch diese Stellbewegung werden die fotovoltaischen Elemente 3 verschwenkt und dadurch der Höhe des Sonnenstandes nachgeführt.

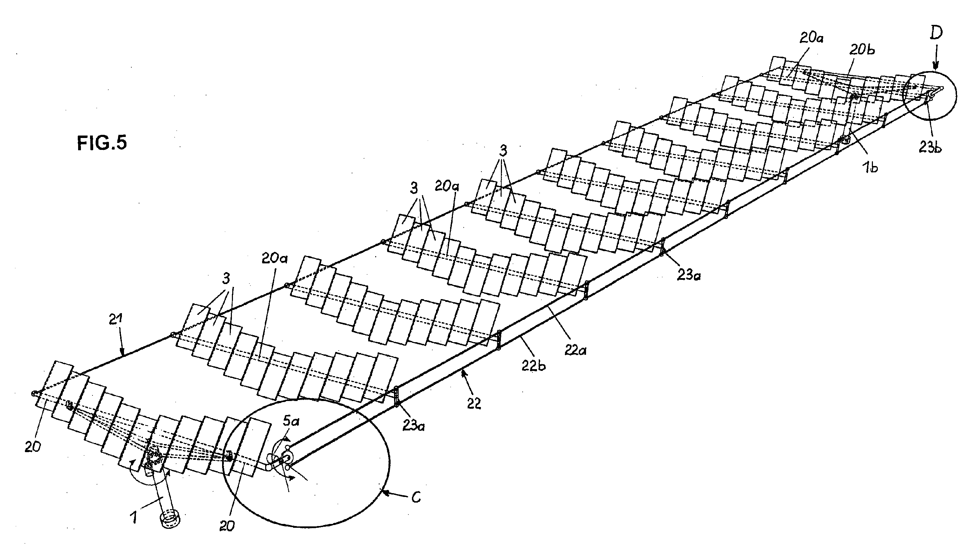

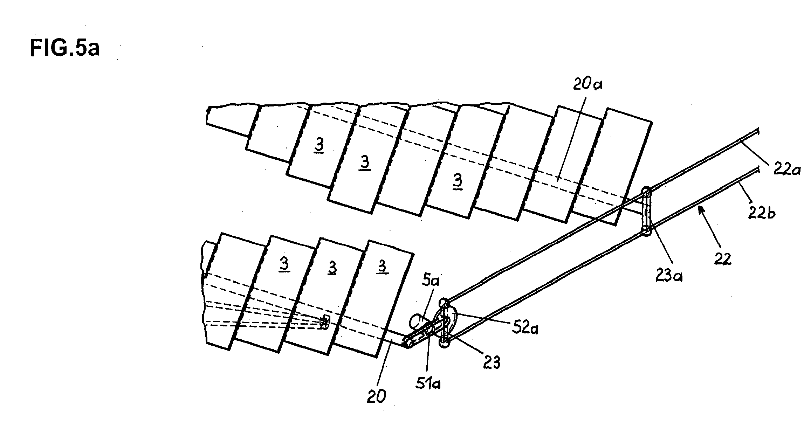

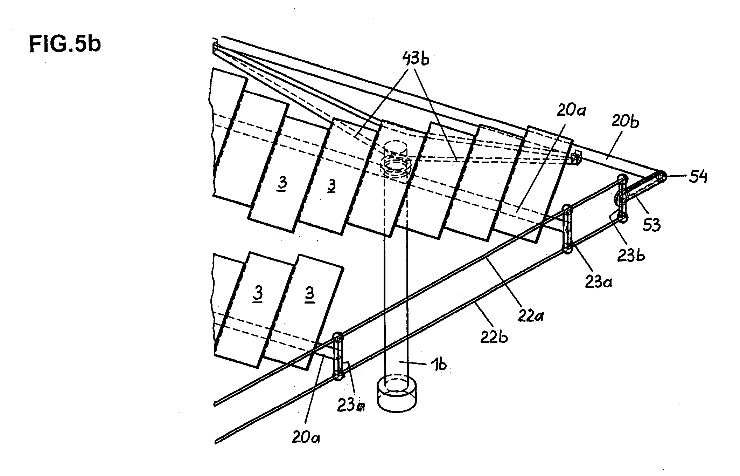

Die in den FIG.5, FIG.5a und FIG.5b dargestellte zweite Ausführungsform einer erfindungsgemäßen Anlage unterscheidet sich von der ersten Ausführungsform nur dadurch, dass der Antriebsmotor 5a für das Trag- und Stellseil 22 am Tragbalken 20 angeordnet ist und über ein Ritzel 51a ein am Tragbalken 20 gelagertes Zahnrad 52a verdreht, an welches die beiden Trume 22a und 22b angelenkt sind. Der Tragbalken 20b ist mittels eines Stellbalkens 43b an der Tragsäule 1b verschwenkbar gelagert. Weiters ist an die Querstrebe 23b ein Lenker 53 angelenkt, welcher über ein Kugelgelenk 54 an den Tragbalken 20b angelenkt ist.

Bei diesem Ausführungsbeispiel werden somit die beiden Trume 22a und 22b des Tragund Stellseiles 22 mittels des Antriebsmotors 5a gegeneinander verstellt, wobei durch diese Stellbewegung die Querstreben 23a verschwenkt werden, wodurch die Tragbalken 20a verdreht werden. Hierdurch erfolgt die Verschwenkung der fotovoltaischen Elemente 3 zu deren Einstellung auf den Höhenstand der Sonne. Die Verstellung der Tragbalken 20a entsprechend der Ost-West-Bewegung der Sonne erfolgt in gleicher Weise wie beim ersten Ausführungsbeispiel durch die Verschwenkung des Tragbalkens 20, wobei diese Verschwenkung über das Trag- und Stellseil 22 und die zwischen den beiden Trumen 22a und 22b vorgesehenen Querstreben 23a auf die Tragbalken 20a übertragen wird.

Ergänzend wird darauf verwiesen, dass die auf den Tragbalken 20 und 20a befestigten fotovoltaischen Elemente 3 gegeneinander in ihrer Höhe versetzt sind, wodurch eine Abschattung durch andere fotovoltaische Elemente 3 weitgehend vermieden wird. Weiters wird darauf verwiesen, dass die konstruktive Gestaltung einer derartigen Anlage auch so gewählt sein kann, dass sich im mittleren Bereich eine Tragsäule mit Stellmotoren befindet, von welcher sich das Tragwerk für die fotovoltaischen Elemente nach beiden Seiten hin erstreckt, wobei an den beiden äußeren Enden jeweils eine weitere Tragsäule od.dgl. für das Tragwerk vorgesehen ist.

## Patentansprüche

1. Anlage zur Gewinnung von elektrischer Energie mittels fotovoltaischer Elemente (3), welche sich auf einem durch Tragseile (21) und Stellseile (22) od.dgl. gebildeten Tragwerk (2) befinden und welche um zumindest angenähert vertikal ausgerichtete Achsen verschwenkbar sind, wodurch sie der Ost-West-Bewegung der Sonne nachführbar sind, sowie weiters um zumindest angenähert horizontal ausgerichtete Achsen verschwenkbar sind, wodurch sie auf die Höhe des Sonnenstandes einstellbar sind, wobei die fotovoltaischen Elemente (3) auf mehreren zueinander zumindest angenähert parallelen und angenähert horizontal ausgerichteten Tragbalken (20, 20a) od.dgl. befestigt sind, wobei die Tragbalken (20, 20a) od.dgl. an einem ihrer beiden Enden an einem Tragseil (21) od.dgl. einerseits um eine zumindest angenähert vertikale Achse verschwenkbar und andererseits um ihre Längsachse verdrehbar gelagert sind und wobei die Tragbalken (20, 20a) an ihrem anderen Ende mit einer Schwenk- und Dreheinrichtung, welche durch zumindest ein Trag- und Stellseil (22) gebildet ist, gekuppelt sind, **dadurch gekennzeichnet, dass** mindestens einer der Tragbalken (20) auf einer Tragsäule (1), Tragstütze od.dgl. gegenüber dieser um seine horizontal ausgerichtete Achse verdrehbar und um eine vertikale Längsachse der Tragsäule (1), Tragstütze od.dgl. verschwenkbar gelagert ist, und dass weiters auf einer der Tragsäulen (1) od.dgl. einerseits eine Schwenkeinrichtung (4) und andererseits eine Dreheinrichtung (5) für diesen Tragbalken (20) vorgesehen sind.

2. Anlage nach Patentanspruch 1, **dadurch gekennzeichnet, dass** die Schwenk- und Dreheinrichtung durch ein mit zwei zueinander angenähert parallelen Trumen (22a, 22b) versehenes Trag- und Stellseil (22) od.dgl. gebildet ist, welches in seiner Längsrichtung verstellbar ist und dessen beide Trume (22a, 22b) gegeneinander verstellbar sind.

3. Anlage nach Patentanspruch 2, **dadurch gekennzeichnet, dass** sich zwischen den beiden Trumen (22a, 22b) des Trag- und Stellseiles (22) an diese angelenkte Querstreben (23, 23a) befinden, welche mit den zugeordneten Enden der Tragbalken (20, 20a) fest verbunden sind.

4. Anlage nach Patentanspruch 2, **dadurch gekennzeichnet, dass** die Schwenkbewegungen und die Drehbewegungen des auf der Tragsäule (1), Tragstütze od.dgl. gelagerten Tragbalkens (20) über die Längsverstellung des mit diesem Tragbalken (20) gekuppelten Trag- und Stellseiles (22) und über die gegenläufige Verstellung der beiden Trume (22a, 22b) des Trag- und Stellseiles (22) auf die anderen Tragbalken (20a) übertragbar sind.

5. Anlage nach einem der Patentansprüche 1 bis 4, **dadurch gekennzeichnet, dass** an den beiden Enden des durch Trag- und Stellseile (21, 22) od.dgl. gebildeten Tragwerkes (2) jeweils eine Tragsäule (1, 1b), Tragstütze od.dgl. vorgesehen ist, an welchen die dort befindlichen Tragbalken (20, 20b) verschwenkbar bzw. verdrehbar gelagert sind, dass mindestens eine der beiden Tragsäulen (1, 1b), Tragstützen od.dgl. mit Antrieben (4, 5) für die Verschwenkung bzw. für die Verdrehung des zugeordneten Tragbalkens (20) ausgebildet ist und dass die Tragbalken (20, 20a) für die fotovoltaischen Elemente (3) an einem ihrer beiden Enden an einem Tragseil (21) um eine zumindest angenähert vertikale Achse verschwenkbar sowie um ihre Längsachse verdrehbar gelagert und mittels des den anderen Enden zugeordneten Trag- und Stellseiles (22) miteinander auf Verschwenkung in einer zumindest angenähert horizontalen Ebene sowie auf Verdrehung um ihre Längsachse gekuppelt sind.

## Claims

1. System for generating electrical energy by means of photovoltaic elements (3), which are located on a supporting framework (2) formed by supporting cables (21) and adjusting cables (22) or the like, and which can be pivoted about at least approximately vertically oriented axes, as a result of which they can track the east-west movement of the sun, and which furthermore can be pivoted about at least approximately horizontally oriented axes, as a result of which they can be adjusted to the solar altitude, wherein the photovoltaic elements (3) are attached on a plurality of supporting beams (20, 20a) or the like, which are oriented at least approximately parallel to each other and approximately horizontally, wherein the supporting beams (20, 20a) or the like can be pivoted at one of the two ends thereof on a supporting cable (21) or the like about an at least approximately vertical axis and are mounted rotatably about the longitudinal axis thereof, and wherein the supporting beams (20, 20a) are coupled at the other end thereof to a pivoting and rotating device, which is formed by at least one supporting and adjusting cable (22), **characterized in that** at least one of the supporting beams (20) is mounted on a supporting column (1), supporting post or the like, in such a way that it can rotate with respect thereto about its horizontally oriented axis and can pivot about a vertical longitudinal axis of the supporting column (1), supporting post or the like, and that furthermore, firstly a pivoting device (4) and secondly a rotating device (5) are provided for this supporting beam (20) on one of the supporting columns (1) or the like.

2. System according to claim 1, **characterized in that** the pivoting and rotating device is formed by a supporting and adjusting cable (22) or the like, which is provided with two strands (22a, 22b) which are approximately parallel to one another, it being possible for said supporting and adjusting cable (22) to be moved in the longitudinal direction thereof and for the two strands (22a, 22b) thereof to be adjusted with respect to one another.

3. System according to claim 2, **characterized in that** transverse struts (23, 23a), which are fixedly connected to the associated ends of the supporting beams (20, 20a), are located between the two strands (22a, 22b) of the supporting and adjusting cable (22).

4. System according to claim 2, **characterized in that** the pivoting movements and the rotating movements of the supporting beam (20), which is mounted on the supporting column (1), supporting post or the like, are transferrable to the other supporting beams (20a) via the longitudinal adjustment of the supporting and adjusting cable (22), which is coupled to said supporting beam (20), and via the adjustment in the opposite direction of the two strands (22a, 22b) of the supporting and adjusting cable (22).

5. System according to any one of claims 1 to 4 **characterized in that** in each case one supporting column (1, 1b), supporting post or the like is provided at the two ends of the supporting framework (2), which is formed by supporting and adjusting cables (21, 22) or the like, wherein the supporting beams (20, 20b) located there are pivotably or rotatably mounted on said supporting column, supporting post or the like, **in that** at least one of the two supporting columns (1, 1b), supporting posts or the like is designed with drives (4, 5) for pivoting or rotating the associated supporting beam (20) and **in that** the supporting beams (20, 20a) for the photovoltaic elements (3) are mounted at one of the two ends thereof on a supporting cable (21) so that they are pivotable about an at least approximately vertical axis and rotatable about their longitudinal axis, and are coupled together by means of the supporting and adjusting cable (22) associated with the other ends so as to enable pivoting in an at least approximately horizontal plane and rotation about their longitudinal axis.

## Revendications

1. Installation de production d'énergie électrique au moyen d'éléments photovoltaïques (3) qui se trouvent sur une structure porteuse (2) formée par des câbles porteurs (21) et des câbles de réglage (22) ou similaires, et qui peuvent pivoter sur des axes alignés au moins presque verticalement, ce par quoi ils peuvent suivre le déplacement est-ouest du soleil, et peuvent ainsi pivoter en outre sur des axes alignés au moins presque horizontalement, ce par quoi ils peuvent être réglés à la hauteur du soleil, dans laquelle les éléments photovoltaïques (3) sont fixés sur une pluralité de barres porteuses (20, 20a) ou similaire alignées au moins presque parallèlement et presque horizontalement entre elles, dans lequel les barres porteuses (20, 20a) ou similaire, sur une de leurs deux extrémités sur un câble porteur (21) ou similaire, sont disposées de façon pivotante sur un axe au moins presque vertical d'une part et rotatives sur leur axe longitudinal d'autre part, et dans lequel les barres porteuses (20, 20a) sont couplées, par leur autre extrémité, à un dispositif de pivotement et de rotation qui est formé par au moins un câble porteur et de réglage (22), **caractérisée en ce qu'**au moins une des barres porteuses (20) est disposée sur une colonne porteuse (1), une tubulure porteuse ou similaire en pouvant tourner par rapport à celles-ci sur son axe aligné horizontalement et en pouvant pivoter sur un axe longitudinal vertical de la colonne porteuse (1), tubulure porteuse ou similaire, et qu'en outre, un dispositif de pivotement (4) d'une part et un dispositif de rotation (5) pour ces barres porteuses (20) d'autre part sont prévus sur une des colonnes porteuses (1) ou similaire.

2. Installation selon la revendication 1, **caractérisée en ce que** le dispositif de pivotement et de rotation est formé par un câble porteur et de réglage (22) ou similaire doté de deux torons (22a, 22b) presque parallèles entre eux, qui est réglable dans son sens longitudinal et dont les deux torons (22a, 22b) sont réglables entre eux.

3. Installation selon la revendication 2, **caractérisée en ce que** des mâts transversaux (23, 23a) se trouvent entre les deux torons (22a, 22b) du câble porteur et de réglage (22) en étant articulés sur ceux-ci, lesquels sont reliés fixement aux extrémités correspondantes des barres porteuses (20, 20a) .

4. Installation selon la revendication 2, **caractérisée en ce que** les mouvements de pivotement et les mouvements de rotation de la barre porteuse (20) montée sur la colonne porteuse (1), la tubulure porteuse ou similaire peuvent être transmis aux autres barres porteuses (20a) par le déplacement longitudinal du câble porteur et de réglage (22) couplé à cette barre porteuse (20) et par le déplacement opposé des deux torons (22a, 22b) du câble porteur et de réglage (22).

5. Installation selon l'une des revendications 1 à 4, **caractérisée en ce qu'**une colonne porteuse (1, 1b), une tubulure porteuse ou similaire respective est prévue sur les deux extrémités de la structure porteuse (2) formée par des câbles porteurs et de réglage (21, 22) ou similaire, sur lesquelles les barres porteuses (20, 20b) présentes sont pivotantes, respectivement rotatives, qu'au moins une des deux colonnes porteuses (1, 1b), tubulure porteuse ou similaire est formée d'entraînements (4, 5) pour le pivotement, respectivement la rotation de la barre porteuse (20) correspondante, et que les barres porteuses (20, 20a) pour les éléments photovoltaïques (3), sur une de leurs deux extrémités sur un câble porteur (21) sont disposées pivotantes sur un axe au moins presque vertical ainsi que rotatives sur leur axe longitudinal et sont couplées entre elles au moyen du câble porteur et de réglage (22) correspondant aux autres extrémités de façon à permettre le pivotement dans un plan au moins presque horizontal ainsi que la rotation sur leur axe longitudinal.
